# EUROPEAN PATENT APPLICATION

(11) **EP 4 841 275 A1**
(43) Date of publication of application: **18.11.2026**
(21) Application number: 26174158.1
(22) Date of filing: 23.04.2026
(51) Int. Cl.: G01R 31/34, H02P 29/024

(54) **DETECTION METHODS FOR FAULTS IN INDUCTION MOTORS**

(30) Priority: 13.05.2025 US 202519206832
(71) Applicant: ABB Schweiz AG, 5400 Baden (CH)
(72) Inventor: CHOOBINEH, Moein, Cary, 27519 (US); GONG, Huangjie, Raleigh, 27607 (US); FADDEL MOHAMED, Samy, Clayton, 27527 (US)
(74) Representative: Maiwald GmbH

(57) **Abstract**

Systems and methods for detecting and classifying faults in induction motors may include an induction motor, a current sensor, an accelerometer, and a processor configured to analyze both current and vibration data. Persistent sideband frequencies may be identified and compared to known fault signatures and vibration thresholds to classify faults. As a result, the described system may enable reliable fault detection across varying motor configurations and loading conditions without frequent recalibration and in a non-invasive manner. Various other apparatuses, systems, and methods are also disclosed.

## Description

### BACKGROUND

Electrical induction motors are used within various industrial processes worldwide, playing a pivotal role in driving machinery and equipment. The efficient operation of these motors is crucial not only for productivity but also for reducing energy consumption and associated costs. Identification of faults in induction motors can help maintenance teams timely replace and/or repair motors that have broken components (e.g., rotor bars, bearings, stators, etc.) or that are otherwise not running as designed.

### BRIEF DESCRIPTION OF THE DRAWINGS

The accompanying drawings illustrate a number of example embodiments and are a part of the specification. Together with the following description, these drawings demonstrate and explain various principles of the present disclosure.
FIG. 1 is a schematic diagram of a motor system including a fault identification platform, according to at least one embodiment of the present disclosure.
FIG. 2 is a plot of frequency and power spectrum data obtained during healthy operation and faulty operation of an induction motor, according to at least one embodiment of the present disclosure.
FIG. 3 is a flow diagram illustrating a method of identifying induction motor faults, according to at least one embodiment of the present disclosure.
FIG. 4 is a plot of frequency and power spectrum data obtained during healthy operation and faulty operation of an induction motor, according to at least one additional embodiment of the present disclosure.
FIG. 5 is a graph illustrating the presence or lack of sideband frequencies during different time segments of motor operation, according to at least one embodiment of the present disclosure.
FIG. 6 is a flowchart of an example method for detecting faults, according to at least one embodiment of the present disclosure.

Throughout the drawings, identical reference characters and descriptions indicate similar, but not necessarily identical, elements. While the example embodiments described herein are susceptible to various modifications and alternative forms, specific embodiments have been shown by way of example in the drawings and will be described in detail herein. However, the example embodiments described herein are not intended to be limited to the particular forms disclosed. Rather, the present disclosure covers all modifications, equivalents, and alternatives falling within the scope of the appended claims.

### DETAILED DESCRIPTION OF EXAMPLE EMBODIMENTS

The problem addressed by the present disclosure lies in the accurate and efficient identification and classification of faults in induction motors, which are important components in industrial applications. Conventional methods for fault detection often rely on invasive techniques requiring access to internal motor components or extensive sensor arrays, which can be costly, time-consuming, and impractical for many operational environments. Non-invasive approaches, such as Motor Current Signature Analysis (MCSA), have previously been explored, but these methods are typically limited to detecting specific fault types or lack the robustness to distinguish between multiple fault categories. Additionally, existing solutions often fail to account for typical oscillations in motor operation, leading to false positives, or require extensive manual calibration of thresholds, which reduces their scalability and adaptability across different motor configurations and loading conditions.

The present disclosure introduces an automated fault identification and classification method that addresses at least some of these limitations by providing a comprehensive, non-invasive solution capable of detecting and classifying multiple fault types in induction motors with high accuracy and efficiency. The described approach leverages a combination of advanced statistical techniques, specialized algorithms, and robust system architecture to tackle the challenges associated with fault detection. In some embodiments, methods of the present disclosure may utilize Motor Current Signature Analysis (MCSA) to analyze the current spectra for sideband frequencies indicative of faults, while incorporating vibration data from an accelerometer to improve detection of bearing-related issues. The method employs a multi-step process that includes data conditioning and standardization, sideband frequency calculation, deadzone adjustment using the Interquartile Range (IQR) method, and a signature confirmation procedure based on temporal segmentation. These advancements enable the system to accurately identify persistent sideband frequencies associated with faults while filtering out routine oscillations and/or transient anomalies.

By integrating these elements, methods and systems of the present disclosure may achieve several notable advantages over conventional approaches. This method removes the need for invasive measurements, minimizes false positives through robust thresholding and deadzone application, and offers a unified framework for detecting and classifying up to eight distinct fault types, including broken rotor bars, rotor eccentricity (dynamic, static, and mixed), bearing faults (outer race, inner race, ball defect), and stator interturn short circuits. Additionally, the method is designed to function effectively across varying motor configurations and loading conditions without requiring frequent recalibration, enhancing its adaptability and scalability. The method's capability to validate frequency signatures and confirm fault presence through temporal segmentation ensures reliable and repeatable results, even in complex operational environments.

Features from any of the embodiments described herein may be used in combination with one another in accordance with the general principles described herein. These and other embodiments, features, and advantages will be more fully understood upon reading the following detailed description in conjunction with the accompanying drawings and claims.

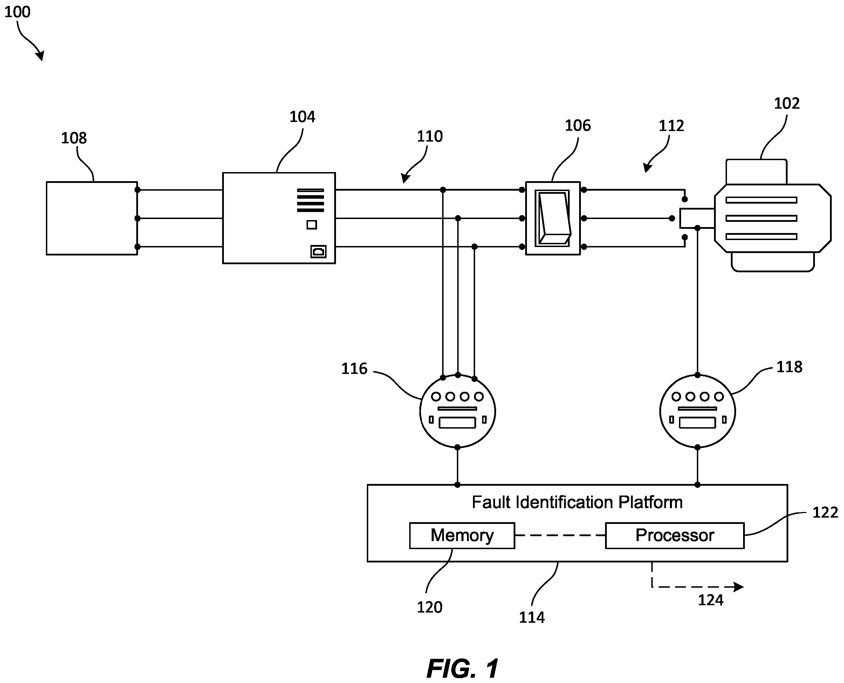

FIG. 1 is a schematic diagram of a motor system including a fault identification platform, according to at least one embodiment of the present disclosure.

In some embodiments, the motor system 100 may include a comprehensive assembly configured to facilitate the operation, monitoring, and fault detection of an induction motor 102. The motor system 100 may include various components, such as a variable speed drive (VSD) 104, a motor switch 106, a current sensor 116, an accelerometer 118, and a fault identification platform 114, all operatively interconnected by electrical connections and powered by a source 108. For example, a first electrical connection 110 may connect the VSD 104 to the motor switch, and a second electrical connection 112 may connect the motor switch 106 to the induction motor 102. In some examples, each component may be arranged to facilitate efficient operation and to support fault detection capabilities of the motor system 100.

The source 108 may provide electrical power to the motor system 100. In some embodiments, the source 108 may be implemented as a three-phase power supply, which may be employed in industrial applications designed to drive induction motors. The source 108 may be configured to deliver electrical energy to the motor system 100. The source 108 may be configured to support the operation of the induction motor 102 (e.g., through the VSD 104 and motor switch 106) and the fault identification platform 114.

In some embodiments, the VSD 104 may be operatively connected to both the source 108 and the motor switch 106 via the first electrical connection 110. The VSD 104 may be configured to control the speed and/or torque of the induction motor 102, such as by adjusting the frequency and voltage of the electrical power supplied thereto. For example, the VSD 104 may include advanced control algorithms to control motor performance under varying load conditions and may also be configured to facilitate the integration of fault detection mechanisms by providing real-time operational data (e.g., motor speed and/or load) to the fault identification platform 114.

The motor switch 106 may be connected to the VSD 104 via the first electrical connection 110 and to the induction motor 102 via the second electrical connection 112. In some embodiments, the motor switch 106 may function as an intermediary control device configured to interrupt and/or redirect the electrical power flow to the induction motor 102. For example, the motor switch 106 may be implemented as a contactor or circuit breaker to provide both safety and operational flexibility. In some embodiments and/or for some identified faults, the motor switch 106 may be configured to isolate the induction motor 102 from the VSD 104 and/or from the source 108 upon detection of a fault, thereby preventing further damage to the induction motor 102 or the motor system 100.

The induction motor 102 may be configured to convert electrical energy into mechanical energy, such as for driving industrial machinery and equipment. For example, the induction motor 102 may be operatively connected to the motor switch 106 via the second electrical connection 112. In some embodiments, the induction motor 102 may include various specifications (e.g., rotor slot number, number of poles, and slip) that may be configured and/or pre-identified to facilitate fault identification and classification.

The fault identification platform 114 may be configured to analyze data from a current sensor 116 and an accelerometer 118 in order to detect and classify motor faults. In some embodiments, the fault identification platform 114 may include a memory 120 and a processor 122 arranged to execute a fault detection algorithm. For example, the fault identification platform 114 may utilize advanced statistical techniques, such as data standardization, deadzone adjustment, and/or sideband frequency computation and identification, to identify persistent sideband frequencies and to validate fault signatures. In some embodiments, the fault identification platform 114 may be configured to operate across various motor configurations and load conditions without requiring frequent recalibration.

In some examples, the current sensor 116 may be operably coupled to the first electrical connection 110 to measure one or more operating electrical currents of the first electrical connection 110. For example, the current sensor 116 may be implemented as a Hall-effect sensor or a shunt resistor to provide accurate and reliable data. As illustrated in FIG. 1, the first electrical connection 110 may include three connections (e.g., cables, wires, etc.) for three respective electrical phases used to drive the induction motor 102. In this case, the current sensor 116 may generate respective current data from all three of the electrical phase connections. The current sensor 116 may supply the current data to the fault identification platform 114 for analysis. The current data output by the current sensor 116 may be utilized by the fault identification platform 114 to analyze frequency spectra and to detect sideband frequencies that may be indicative of motor faults (e.g., broken rotor bars or stator interturn short circuits), as further explained below.

In some examples, the accelerometer 118 may be operably coupled to the induction motor 102 to sense vibrations in the induction motor 102 and to generate corresponding vibration data. For example, the accelerometer 118 may be coupled to a housing of the induction motor 102, to a drive end of the induction motor 102, and/or to a non-drive end of the induction motor 102. For example, the accelerometer 118 may be implemented as a piezoelectric or MEMS-based sensor, which may provide the vibration data with high sensitivity and precision. The accelerometer 118 may supply the vibration data to the fault identification platform 114 for analysis. For example, the vibration data may be used to detect bearing-related faults (e.g., outer race, inner race, and ball defect faults). In some embodiments, the accelerometer 118 may also be configured to provide speed data, which may be used to compute slip and/or other parameters for fault identification.

In some embodiments, the memory 120 may be operatively connected to the processor 122 within the fault identification platform 114. The memory 120 may be configured to store baseline data for healthy motor operation, fault detection algorithms, and/or known frequency signatures for various fault types. Accordingly, the memory 120 may store instructions that, when executed by the processor 122, cause the processor 122 to perform fault detection operations as described herein. For example, the memory 120 may be implemented as nonvolatile storage (e.g., flash memory or solid-state drives) to ensure data retention even during power interruptions. As a result, the memory 120 may facilitate the comparison of real-time data with stored healthy data to enable accurate fault detection and classification.

The processor 122 may be operatively connected to the memory 120 and other components of the fault identification platform 114. The processor 122 may be configured to execute the fault detection algorithm. For example, a fault detection algorithm may include operations such as Fourier transform (e.g., discrete Fourier transform (DFT), fast Fourier transform (FFT), etc.), residual calculations, and frequency signature confirmation. In some embodiments, the processor 122 may be implemented as a microcontroller or a digital signal processor (DSP) to provide high computational power and efficiency. The processor 122 may interact with the current sensor 116 and the accelerometer 118 to receive real-time data (e.g., current data and vibration data) and to perform temporal segmentation of the data to facilitate robust and accurate fault detection.

In some embodiments, the fault identification platform 114 may generate an alarm 124 to notify a user of any detected faults. For example, the alarm 124 may be implemented as an audible buzzer, visual indicator, and/or digital notification system. The alarm 124 may be configured to be activated by the processor 122 when a fault is identified, thereby providing immediate feedback to maintenance personnel. In some embodiments and/or for some identified faults, activation of the alarm 124 may also include stopping operation of the induction motor 102, such as by toggling the motor switch 106. The alarm 124 may contribute to improving the safety and reliability of the motor system 100 by supporting prompt intervention in the event of a fault.

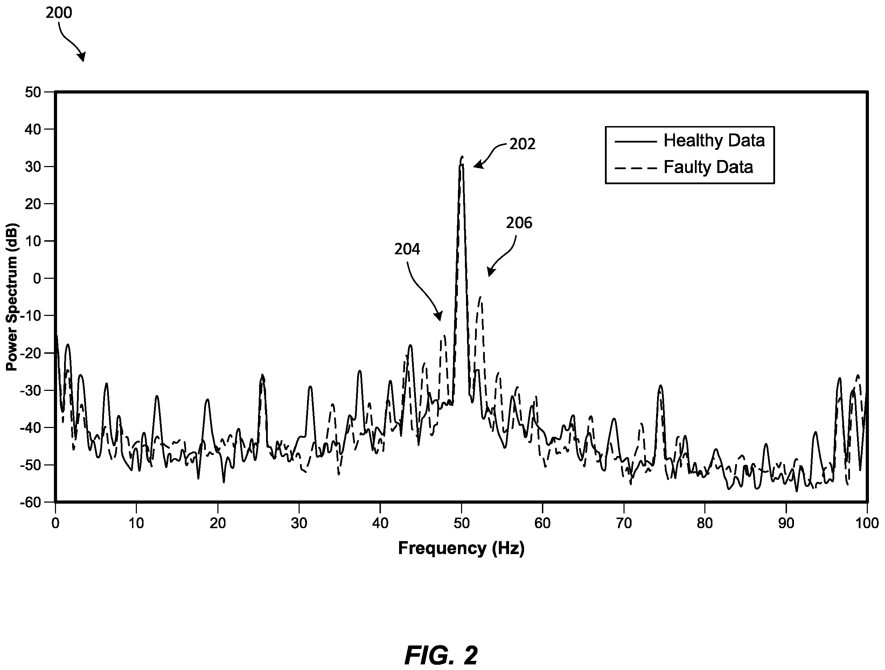

FIG. 2 is a plot 200 of frequency and power spectrum data obtained during healthy operation and faulty operation of an induction motor, according to at least one embodiment of the present disclosure.

The plot 200 in FIG. 2 may represent frequency spectrum data obtained during the operation of an induction motor. The plot 200 may serve as a visual representation of the power spectrum (in decibels) as a function of frequency (in Hertz). Accordingly, the plot 200 may be configured as a component in a fault detection and classification process, such as may be performed by the fault identification platform 114 of FIG. 1.

The visual representation of the plot 200 in FIG. 2 may provide a comparative analysis of healthy and faulty motor conditions. For example, the solid line in the plot 200 may correspond to a frequency spectrum of a healthy motor, while the dashed line may represent the frequency spectrum of a motor exhibiting a fault.

In some embodiments, the differences between these two spectra, such as at specific frequencies, may be used to identify and classify one or more faults. Furthermore, the plot 200 may be generated by applying a Fourier Transform, such as a Fast Fourier Transform (FFT), to current data collected by a current sensor (e.g., current sensor 116) at a current input to a motor (e.g., induction motor 102). The transform may be used to convert the time-domain current signal into a frequency-domain representation to enable the identification of sideband frequencies associated with various fault types.

Over time, a primary peak frequency 202 may be determined as the most prominent frequency component in the plot 200. This frequency may typically correspond to the main frequency of the motor's operation and may function as a baseline reference for analyzing performance and/or detecting anomalies. In some embodiments, the primary peak frequency 202 may be derived from the current data and may be influenced by the motor's operating conditions, such as speed and/or load.

In the context of fault detection, the primary peak frequency 202 may serve as a reference point for identifying sideband frequencies indicative of specific faults. For example, in some embodiments involving a broken rotor bar fault, sideband frequencies may appear around the primary peak frequency 202. The primary peak frequency 202 may be accurately identified to facilitate the calculation of these sideband frequencies and to ensure reliability in the fault detection process.

In some embodiments, a first sideband frequency 204 and a second sideband frequency 206 may be configured as additional frequency components that appear near the primary peak frequency 202 in the presence of a fault. The first sideband frequency 204 and second sideband frequency may be compared to frequencies present from predefined equations, which may be specific to each fault type. For example, in embodiments involving a broken rotor bar fault, the first sideband frequency 204 and second sideband frequency 206 may be present in the expression *f_{BRB} =* (1 ± 2*s*)*fₛ*, where *s* may denote the slip of the motor and *fₛ* may denote the primary (e.g., fundamental) frequency. This expression includes a plus or minus operator. The first sideband frequency 204 may be associated with the minus and the second sideband frequency 206 may be associated with the plus. Accordingly, the first sideband frequency 204 and the second sideband frequency 206 may be used as an indicator of the fault's presence and may facilitate assessment of the fault's severity.

In some embodiments, the amplitude and persistence of the first sideband frequency 204 and the second sideband frequency 206 across multiple time segments of data collection may be analyzed to confirm the fault. Further, the detection of the first sideband frequency 204 and the second sideband frequency 206 may involve comparing their amplitudes to a threshold and ensuring that they falls within a predefined proximity range around the calculated value. In some embodiments, a deadzone may be applied to filter out oscillations and transient anomalies.

Further examples and details relating to the identification and classification of faults based on the presence of these sideband frequencies across all time segments will be explained below.

For example, the frequency spectrum may be calculated for current data during a time period and then compared to various known equations for different fault types.

As noted above, for broken rotor bar faults, the sideband frequencies may be approximated by the following equation (1): ${f}_{BRB} = \left(1\pm 2s\right) {f}_{s}$ (1), where *s* denotes the slip of the motor and *fₛ* denotes the primary (e.g., fundamental) frequency.

Rotor eccentricity faults are categorized into dynamic, static, and mixed types. Dynamic and static eccentricity faults may include sideband frequencies identified by the following equation (2): ${f}_{RE} = \left[\left(kR\pm {n}_{d}\right)\left(\frac{1 - s}{p}\right)\pm v\right] {f}_{s}$ (2), where *k* is any integer number, *R* is the number of rotor slots in the induction motor being monitored, *p* represents a number of pole pairs in the induction motor, and *v* is a stator magnetomotive force (MMF) harmonic order.

Equation (3) may approximate sideband frequencies for mixed rotor eccentricity: ${f}_{RE , Mixed} = \left|{f}_{s}\pm {kf}_{r}\right|$ (3),
where ${f}_{r} = \frac{1 - s}{p} {f}_{s}$.

Bearing faults, including outer race, inner race, and ball defect faults, may also be identified. For example, a bearing fault may be identified by approximating sideband frequencies with the following equation (4) for all of the outer race, inner race, and ball defect faults: ${f}_{B} = \left({f}_{s}\pm {kf}_{o / i / b}\right)$ (4)

The following equations (5), (6), and (7) may be used to identify outer race bearing faults, inner race bearing faults, and ball defect bearing faults, respectively: ${f}_{o} = \frac{{N}_{b}}{2} {f}_{r} \left(1-\frac{{D}_{b}}{{D}_{c}}cos β\right)$ (5), ${f}_{i} = \frac{{N}_{b}}{2} {f}_{r} \left(1∓\frac{{D}_{b}}{{D}_{c}}cos β\right)$ (6) and ${f}_{b} = \frac{{D}_{c}}{{D}_{b}} {f}_{r} \left(1-\frac{{{D}_{b}}^{2}}{{{D}_{c}}^{2}}{cos}^{2} β\right)$ (7), where *N_{b}* is the number of bearing balls, *D_{b}* is the ball diameter, *D_{c}* is the bearing pitch diameter, and *β* is the contact angle of bearing balls on races for the induction motor that is being monitored. It is noted that the parameters *D_{b}, D_{c},* and *β* may not always be available for motors. Accordingly, the outer race bearing fault and inner race bearing fault may also be approximated with the following equations (8) and (9) for most motors having between six and twelve bearing balls: ${f}_{o} = 0.4 \times {N}_{b} \times {f}_{r}$ (8) and ${f}_{o} = 0.6 \times {N}_{b} \times {f}_{r}$ (9).

For stator interturn short circuit faults, the sideband frequencies may be correlated to the following equation (10): ${f}_{SISC} = {f}_{s} \left[\frac{m}{p}\left(1-s\right)\pm k\right]$ (10) where m and *k* are integers.

As shown by these equations, integer values for m and *k* may generate a large set of frequency candidates, sometimes resulting in overlapping frequencies between fault types, which may cause fault classification issues. However, experiments indicate that sideband frequencies may be more detectable in lower-order harmonics. Therefore, limiting the analysis to certain harmonics (such as five or seven) can help prevent these issues. Additionally, it was observed that faults such as broken rotor bars, mixed eccentricity, bearing faults, and stator interturn short circuits are more detectable in the lower end of the spectrum, while dynamic and stator eccentricity are more observable in the higher end. Thus, the sideband frequency search range can be adjusted to identify these different fault types. In some examples, the search ranges may be set around the fundamental value of each equation, aligning with these observations.

These equations may be compared to the frequency spectrum of the motor's current and/or vibration data, enabling precise identification and classification of faults based on the presence and persistence of the sideband frequencies that fit the respective equations. In some embodiments, the frequency spectrum obtained during a motor's operation may be compared to sideband frequencies from the equations to determine whether any sideband frequencies are present within a proximity threshold (e.g., 0.5 Hz, 4 Hz, 8 Hz, 10 Hz, etc.).

In some embodiments, methods and systems according to the present disclosure may incorporate a deadzone adjustment mechanism to filter out routine oscillations and transient anomalies in the frequency spectrum to ensure that only significant changes that may be indicative of faults are evaluated. The deadzone may be defined using the Interquartile Range (IQR) method, which is a statistical tool for identifying outliers. Specifically, the deadzone upper limit may be calculated as *Q*₃ *+k.IQR,* where *IQR = Q*₃ - *Q*₁, *Q*₃ is the 75^{th} percentile of the data, *Q*₁ is the 25^{th} percentile of the data, and *k* is the IQR scale. The IQR scale may be set to 1.5 to encompass approximately 95% of values under the assumption of a standard distribution. This deadzone adjustment may be applied dynamically across a moving window to account for the distinct characteristics of each segment of the frequency spectrum. By ignoring frequency changes that fall within the deadzone, the method may effectively reduce false positives and enhance the reliability of fault detection.

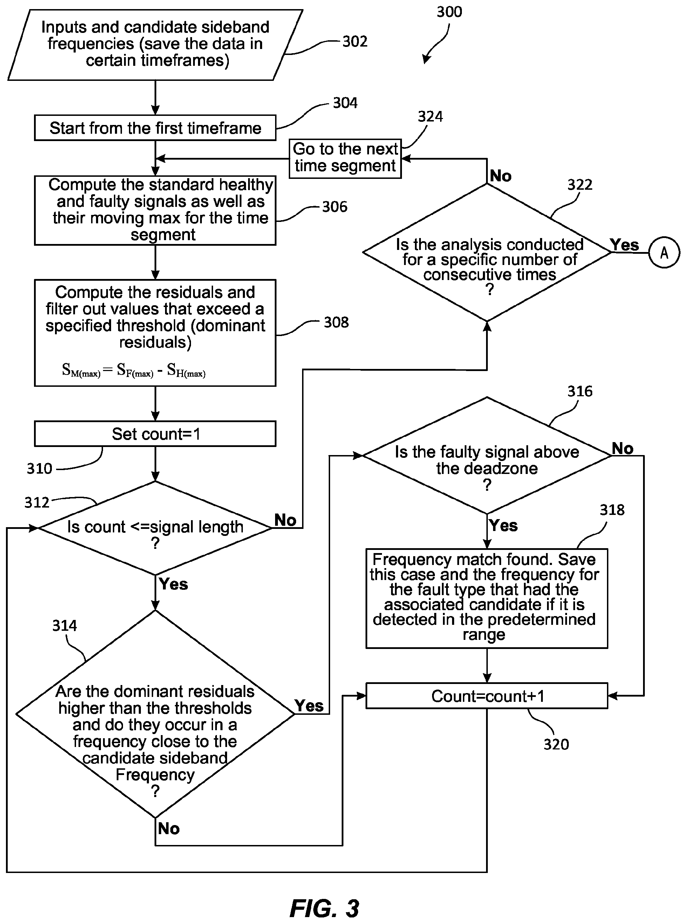

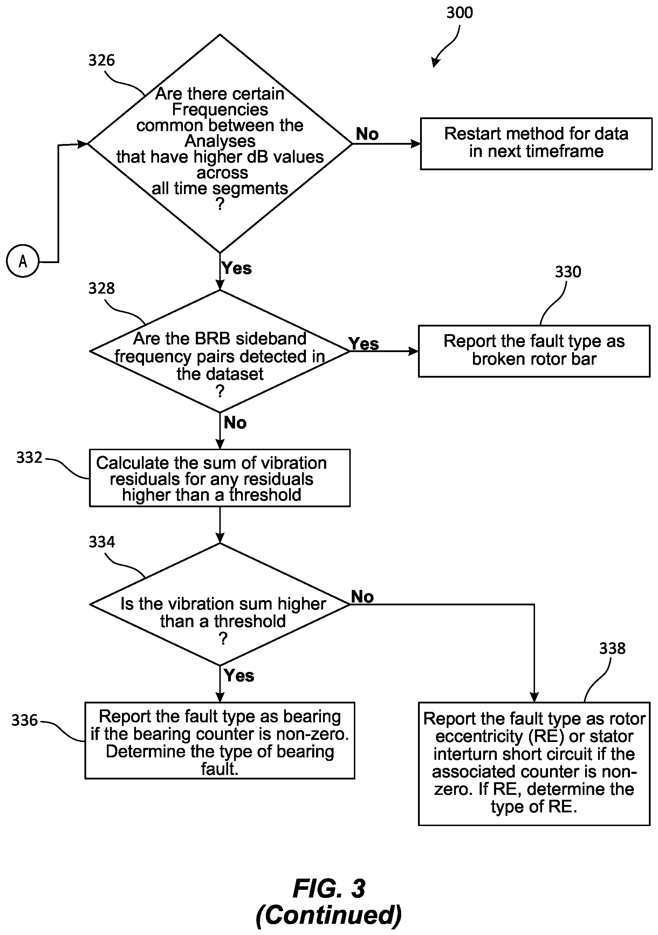

FIG. 3 is a flow diagram illustrating a method 300 of identifying induction motor faults, according to at least one embodiment of the present disclosure.

In some embodiments, block 302 may represent an initial step in a fault detection process, in which inputs and candidate sideband frequencies are determined and saved for analysis. In some cases, the block 302 may include collecting and saving the necessary data, including current and vibration signals, from the induction motor system. The data may be saved in certain timeframes (e.g., one-minute timeframes, ninety-second timeframes, two-minute timeframes, etc.) and the data in each timeframe may be temporally segmented. For example, the data in each timeframe may be saved in data sets corresponding to ten-second segments, fifteen-second segments, twenty-second segments, thirty-second segments, etc. The temporal segmentation may facilitate identification of persistent anomalies across multiple time segments and/or timeframes, thereby reducing the likelihood of false positives.

For example, the current data may be obtained from a current sensor positioned at a motor terminal, along an electrical connection leading to the motor terminal, at a motor switch, and/or at a variable speed drive. The vibration data may be collected from an accelerometer mounted on the motor, such as on a non-drive end, drive end, or motor housing of the motor. These inputs may facilitate identification of sideband frequencies indicative of specific fault types. Candidate sideband frequencies may be calculated using predefined equations tailored to each fault type, such as broken rotor bars, rotor eccentricity, and bearing faults, with these equations incorporating motor parameters like motor slip, rotor slot number, and pole pairs. In this manner, the block 302 may ensure that the collected data and calculated frequencies are stored in a structured format for subsequent processing.

In some embodiments, block 304 may include interacting with the stored data from the block 302, beginning with the first segment of the collected data and setting the stage for iterative processing of each segment to detect and classify faults.

In some embodiments, block 306 may include computing baseline healthy signals and faulty signals for the current time segment. In some instances, this may involve applying data standardization techniques, such as T-score normalization, to align the scales of the collected data with the baseline healthy data stored in the fault identification platform. In this manner, the healthy data may serve as a reference for identifying deviations that may indicate one or more faults. For example, the block 306 may also include computing a moving maximum for both healthy and faulty signals using a sliding window approach, which may assist in isolating dominant residuals that may represent differences between the healthy and faulty signals, with the residuals being subsequently used to identify potential faults.

For example, T-score normalization is a statistical technique that may improve comparability and anomaly detection. This process may involve transforming raw data into a shared scale, thereby aiding the comparison of signals from healthy and faulty motor conditions. The T-score normalization may be expressed with the following equation (11): $t = \frac{\overline{x} - μ}{s / \sqrt{n}}$ (11), where *x̅* represents the sample mean, *µ* represents the population mean, *s* is the sample standard deviation, and *n* is the sample size. The T-score may enhance the identification of variations in the frequency spectrum to facilitate detection of deviations that may suggest motor faults.

In some embodiments, block 308 may include computing the residuals by subtracting the moving maximum of the healthy signal from that of the faulty signal. Accordingly, this operation may highlight differences that can be indicative of potential faults. For example, the block 308 may further include filtering these residuals to retain only the dominant residuals, such as those exceeding a specified threshold. In some embodiments, the specific threshold may be set for each fault type. Threshold values may be determined experimentally, such as based on an amount of variation that is typically present in motors experiencing each fault type (e.g., a higher threshold for high-variation faults and a lower threshold for low-variation faults). As such, the dominant residuals may facilitate identification of sideband frequencies associated with specific fault types.

In some embodiments, block 310 may include setting a counter variable to one. This initialization may facilitate tracking a number of iterations through the time segments. For example, the counter may ensure that all the datapoints within a certain time segment have been analyzed. For example, if there are 10,000 datapoints in each time segment, this counter will proceed from 1 through 10,000.

In some embodiments, decision block 312 may include evaluating whether the current value of the counter is less than or equal to the signal length (e.g., the number of data points) within each time segment . If the condition is true, the process may proceed to decision block 314, described below. If the condition is false, the process may proceed to decision block 322, described below.

In some embodiments, decision block 314 may include checking whether the dominant residuals identified in the block 308 exceed predefined thresholds and occur near the candidate sideband frequencies calculated in block 302. For example, this proximity check may facilitate association of the residuals with specific fault types, as the thresholds may be designed to filter out typical (e.g., normal operation) oscillations and transient anomalies. If the condition is met as a result, the process may proceed to further validate the fault at decision block 316; otherwise, the counter may be incremented and data from the next time segment or timeframe may be analyzed.

In some embodiments, the decision block 316 may include evaluating whether a faulty signal (e.g., as determined by the decision block 314) exceeds the deadzone, which may be defined using the IQR method, to filter out typical variations in the signal. For example, this deadzone may be dynamically adjusted for each time segment to account for the specific characteristics of that segment. Accordingly, if the faulty signal is above the deadzone, a significant anomaly may be indicated, and the process may move to block 318 for further analysis; however, if the signal does not exceed the deadzone, the counter may be incremented and data from the next time segment or timeframe may be analyzed.

In some embodiments, the block 318 may include confirming the presence of a frequency match if the faulty signal exceeds the deadzone and aligns with a candidate sideband frequency. For example, the block 318 may save the identified frequency and may associate the identified frequency with the corresponding fault type. Accordingly, the saved data may support subsequent steps in fault validation and classification. This confirmation ensure that only genuine (e.g., significant) anomalies are considered.

In some embodiments, block 320 may increment the counter variable by one, thereby preparing the process for the analysis of the next time segment. For example, this step may ensure that the iterative analysis may continue until all segments have been processed or a fault has been identified with certainty. After the block 320 increments the counter variable, the process may continue with the decision block 312, described above.

After the decision block 312 determines that the count is not less than or equal to the signal length, the process may continue with decision block 322. In some embodiments, the decision block 322 may include checking whether the analysis has been conducted for a predefined number of consecutive time segments. For example, this condition may facilitate validation of persistence of any identified anomalies, as persistent anomalies may be more likely to indicate genuine faults rather than transient phenomena. Accordingly, if the condition is met, the process may move to block 324 for final fault identification and validation, starting with decision block 326; however, if not, the analysis may continue with data from the next time segment as indicated by block 324 and restarting the process for this next data at the block 306, as described above.

In some embodiments, the decision block 326 may include evaluating whether certain frequencies (e.g., sideband frequencies) are common between analyses conducted across all time segments and whether these frequencies consistently exhibit higher decibel (dB) values. The processor may compare the frequency data from each time segment in one or more timeframes and determine if any frequencies are present across all time segments with dB values exceeding a predefined threshold set to filter out oscillations and transient noise. This may ensure that only frequency changes that may indicate persistent anomalies are considered. For example, the decision block 326 may interact with earlier components, such as the block 308 and the decision block 316, to ensure that the identified frequencies align with candidate sideband frequencies calculated in block 302. In some embodiments, if the condition of the decision block 326 is met, the process may proceed to decision block 328 for further analysis; conversely, if the condition is not met, the process may continue with data from subsequent timeframes.

In some embodiments, the decision block 328 may include determining whether the data set includes sideband frequency pairs that may be associated with broken rotor bar (BRB) faults. BRB faults are typically the easiest (e.g., computationally) to identify, thus improving the efficiency of the fault detection system by attempting to identify BRB faults prior to other fault types.

These sideband frequencies indicative of BRB faults may be calculated using the equation (1) above. The processor may evaluate the frequency matches identified in the block 326 against the predefined BRB sideband frequency pairs. For example, if the detected frequencies are found to align with the calculated sideband frequencies within a proximity threshold (e.g., 0.5 Hz, 4 Hz, 8 Hz, 10 Hz, etc.), the fault may be classified as a BRB fault, and the process may proceed to determination block 330 to report the fault type as a broken rotor bar, such as by generating an output indicating the BRB fault classification and/or triggering an alarm or notification to maintenance personnel. As discussed above, in some examples the system may halt operation of the motor experiencing the BRB fault. On the other hand, if no BRB sideband frequency pairs are detected in the data set, the process may move to block 332 for further fault classification.

In some embodiments, the block 332 may calculate the sum of vibration residuals for any residuals that may exceed a predefined threshold. For example, this operation may facilitate the identification of bearing-related faults, which may be characterized by anomalies in vibration data. The processor may analyze the vibration data collected by the accelerometer and may compute residuals by comparing the measured data against baseline healthy data stored in the fault identification platform. Accordingly, the sum of these residuals may be evaluated to determine whether the threshold is exceeded, thereby indicating a potential bearing fault. In some embodiments, this block may interact with earlier components, such as the block 306 and the decision block 316, to ensure that the vibration data may be standardized and filtered prior to analysis. The calculated sum may then be used in decision block 334 for further fault classification.

In some embodiments, the decision block 334 may include evaluating whether the sum of vibration residuals calculated in block 332 exceeds a predefined threshold set to distinguish between operational vibrations and anomalies that may indicate bearing faults. For example, if the vibration sum is determined to be higher than the threshold, the process may proceed to determination block 336 for bearing fault classification. However, if the vibration sum does not exceed the threshold, the process may move to determination block 338 for further analysis of rotor eccentricity and/or stator interturn short circuit faults.

In some embodiments, the determination block 336 may report the fault type as a bearing fault if the bearing counter is non-zero and if the vibration sum exceeds the threshold. For example, the processor may classify the specific type of bearing fault-such as outer race, inner race, or ball defect-based on the frequency matches identified in earlier blocks. In some embodiments, bearing faults may be characterized by sideband frequencies calculated using equations (4) through (9), discussed above. Accordingly, the determination block 336 may interact with the fault identification platform's memory to retrieve parameters and equations that may facilitate fault classification. Once the fault type is determined, the processor may generate an output indicating the classification and may trigger an alarm, notification, and/or stopping of the motor.

In some embodiments, the determination block 338 may identify and report the fault type as rotor eccentricity (RE) or stator interturn short circuit (SISC) if the associated counter is non-zero and if the vibration sum does not exceed the threshold. The system may be capable of distinguishing between RE or SISC faults based on the sideband frequencies detected. If the persistent sideband frequencies detected belong to the RE candidates, the fault type may be identified as RE. Conversely, if the persistent sideband frequencies belong to the SISC candidates, the fault type may be identified as SISC. RE faults may be further classified into dynamic, static, and mixed types based on the frequency matches identified in earlier blocks. In some embodiments, rotor eccentricity faults may be identified and characterized by sideband frequencies calculated using the equations (2) and (3) discussed above. Similarly, SISC faults may be characterized by sideband frequencies calculated using the equation (10) discussed above

In this manner, the determination block 338 may ensure that rotor eccentricity and stator interturn short circuit fault types are classified based on frequency matches and vibration data. The determination block 338 may also include triggering an alarm, notification, and/or stopping of the motor when a fault is identified.

Accordingly, the method 300 may provide comprehensive fault identification and classification for induction motor fault types with data obtained noninvasively from one or more current sensors, one or more accelerometers, and/or motor parameters.

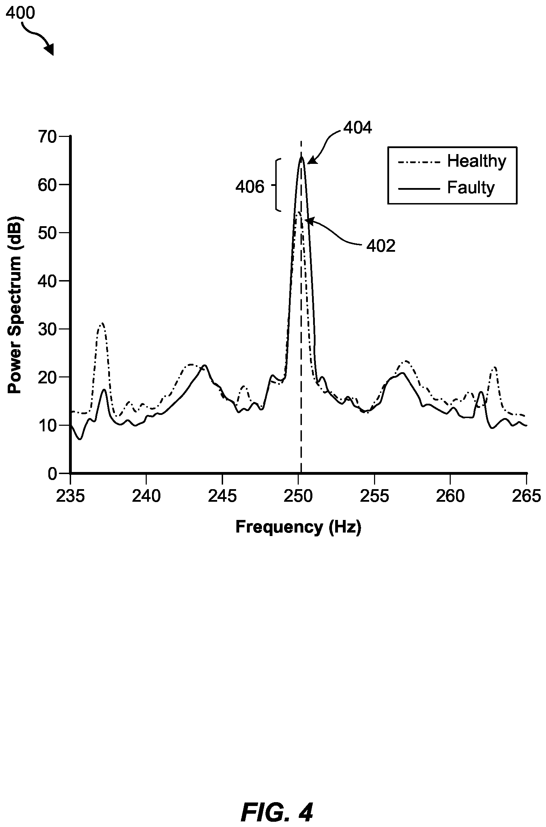

FIG. 4 is a plot 400 of frequency and power spectrum data obtained during healthy operation and faulty operation of an induction motor, according to at least one additional embodiment of the present disclosure. The plot 400 was generated by applying a Fourier Transform, such as a Fast Fourier Transform (FFT), to input electrical current data collected by a current sensor positioned at the motor terminal or along the electrical connection leading to the motor.

The plot 400 represents the power spectrum (in decibels) as a function of frequency (in Hertz). The plot 400 may serve as a comparative tool for analyzing differences between healthy and faulty motor conditions. For example, the dashed line in the plot 400 corresponds to the frequency spectrum of a healthy motor and the solid line corresponds to the frequency spectrum of a motor exhibiting a fault. This plot 400 may facilitate the identification of anomalies, such as sideband frequencies that are indicative of specific fault types, which may then be further analyzed using predefined equations tailored to each fault type, such as broken rotor bars, rotor eccentricity, and bearing faults.

The healthy data may include a healthy peak 402, which may be defined as a prominent frequency component in the frequency spectrum of a motor operating under expected (e.g., non-faulty) operating conditions. The healthy peak 402 may be derived from the current data collected during proper motor operation. Accordingly, the healthy peak 402 may serve as a baseline reference for analyzing deviations in the frequency spectrum that may indicate one or more faults.

In some embodiments, a faulty peak 404 may represent a prominent frequency component in the frequency spectrum of a motor operating under faulty conditions. The faulty peak 404 may be derived from the current data collected during the operation of a motor exhibiting a fault and may typically deviate from the healthy peak 402. The faulty peak 404 may serve as an indicator of anomalies in the motor's operation. The faulty peak 404 may be analyzed alongside and compared to the healthy peak 402 to compute residuals and identify deviations that may suggest faults. In some embodiments, the persistence of the faulty peak 404 across multiple time segments may be used to confirm the presence of a fault and to classify the type of fault.

A difference 406 may exist between the healthy peak 402 and the faulty peak 404. This difference 406 may be calculated by subtracting the healthy signal from the faulty signal, thereby resulting in a residual that may highlight an anomaly indicative of a potential fault. As a result, the difference 406 may facilitate the identification of sideband frequencies associated with specific fault types. For example, the difference 406 may reveal a frequency spike at or near a particular frequency (e.g., the 250 Hz level as shown in the example of FIG. 4), which may be compared to sideband frequencies calculated using predefined equations for fault types such as broken rotor bars, rotor eccentricity, and bearing faults. In some embodiments, the difference 406 may be further analyzed using statistical methods, such as the Interquartile Range (IQR), to filter out typical oscillations and transient anomalies. Additionally or alternatively, the difference 406 may be compared to a predetermined threshold. Furthermore, the persistence of the difference 406 across multiple time segments may be used to validate the presence of a fault and ensure reliability in the fault detection process.

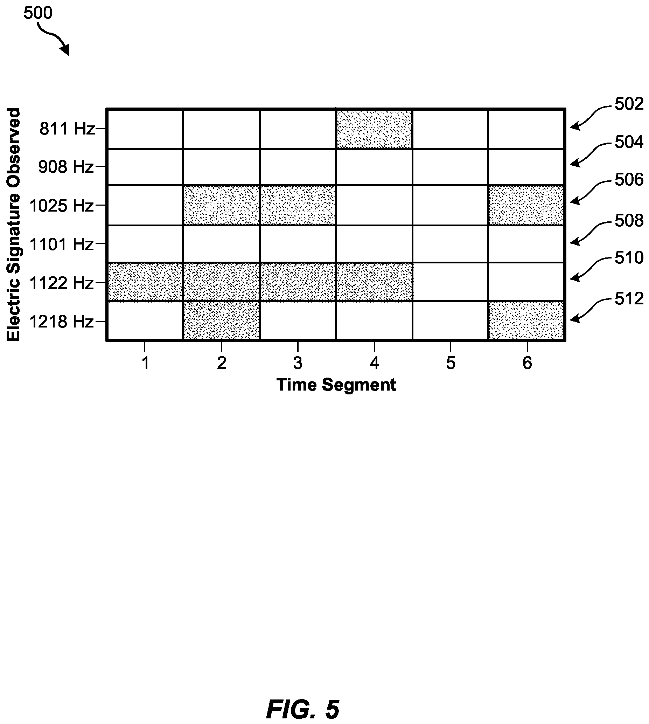

FIG. 5 is a graph 500 illustrating the presence or lack of sideband frequencies during different time segments of motor operation, according to at least one embodiment of the present disclosure. The graph 500 may serve as a visual representation of the temporal segmentation and frequency analysis performed by methods according to at least some embodiments of the present disclosure.

In some cases, each frequency component may be analyzed across multiple time segments to identify persistent anomalies that may be indicative of specific fault types in induction motors. For example, the graph 500 may be configured with rows corresponding to distinct frequency values and/or value ranges and columns representing individual time segments to facilitate a comprehensive evaluation of frequency behavior over time.

In the example shown in FIG. 5, the graph 500 may be used to analyze whether one or more sideband frequencies of six sideband frequencies are persistent across six time segments. By way of example and not limitation, the time segments may each represent ten seconds of data and, therefore, the graph 500 may show one minute of data for analysis. Depending on which, if any, of the sideband frequencies are persistent during all the time segments, the system may identify and/or classify a fault. For example, the equations (1) through (10) above may be used to identify which of the persistent sideband frequencies may be consistent with a particular fault type.

For example, a first frequency 502 may correspond to a first candidate sideband frequency at 811 Hz, a second frequency 504 may correspond to a second candidate sideband frequency at 908 Hz, a third frequency 506 may correspond to a third candidate sideband frequency at 1025 Hz, a fourth frequency 508 may correspond to a fourth candidate sideband frequency at 1101 Hz, a fifth frequency 510 may correspond to a fifth candidate sideband frequency at 1122 Hz, and a sixth frequency 512 may correspond to a sixth candidate sideband frequency at 1218 Hz.

In FIG. 5, a solid white section represents the existence of the particular sideband frequency during the respective time segment. A shaded section represents the lack of the particular sideband frequency during the respective time segment, or at least the insignificant (e.g., below a threshold) presence of the particular sideband frequency.

As shown in FIG. 5, the second frequency 504 and the fourth frequency 508 are persistent across all six of the time segments. On the other hand, the first frequency 502, third frequency 506, fifth frequency 510, and sixth frequency 512 demonstrate respective sideband frequencies that may be present during some of the time segments but are not persistent across all the time segments. Accordingly, the first frequency 502, third frequency 506, fifth frequency 510, and sixth frequency 512 can be considered as temporary conditions and may be disregarded. The second frequency 504 and the fourth frequency 508 may be considered as persistent sideband frequencies in the data set being analyzed.

In the example shown in FIG. 5, by comparing the data to equations (1) through (10) (e.g., using the method 300 of FIG. 3, discussed above), the second frequency 504 of 908 Hz and the fourth frequency 508 of 1101 Hz may be confirmed as sideband frequencies corresponding to a Dynamic Rotor Eccentricity fault.

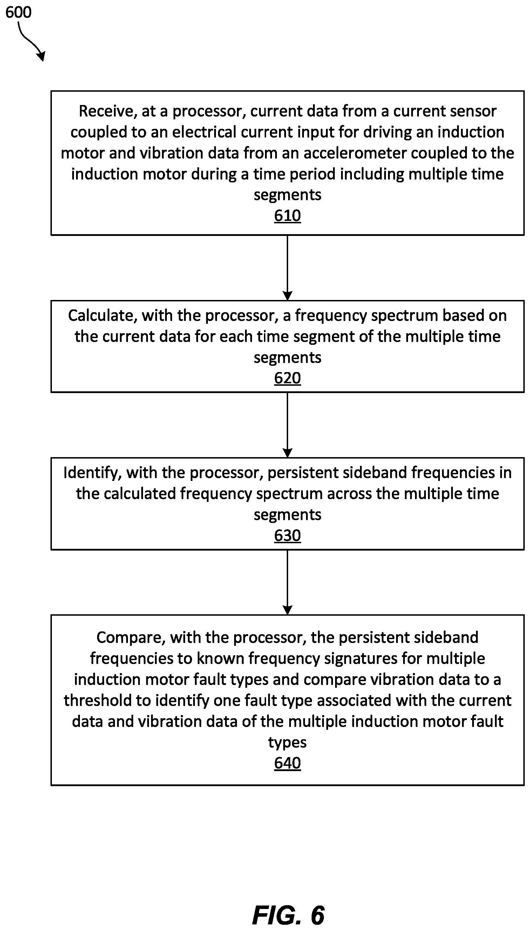

FIG. 6 is a flowchart of an example method 600 for detecting faults, according to at least one embodiment of the present disclosure. At operation 610, current data from a current sensor may be received at a processor. The current sensor may be coupled to an electrical current input for driving an induction motor and vibration data from an accelerometer coupled to the induction motor during a time period including multiple time segments.

At operation 620, a frequency spectrum may be calculated by a processor. The frequency spectrum may be calculated based on the current data for each time segment of the multiple time segments. For example, a Fourier transform (e.g., FFT) may be applied to the current data to obtain the frequency spectrum.

At operation 630, any persistent sideband frequencies in the calculated frequency spectrum may be identified with the processor across the multiple time segments.

At operation 640, the persistent sideband frequencies may be compared with the processor to known frequency signatures for multiple induction motor fault types. For example, the existence of the persistent sideband frequencies may be confirmed by applying a deadzone and/or comparing the sideband frequencies to a threshold across the multiple time segments. Vibration data may also be compared to a threshold. The comparison of the frequencies and of the vibration data may result in the identification of one fault type associated with the current data and vibration data of the multiple induction motor fault types.

The process parameters and sequence of the steps described and/or illustrated herein are given by way of example only and can be varied as desired. For example, while the steps illustrated and/or described herein may be shown or discussed in a particular order, these steps do not necessarily need to be performed in the order illustrated or discussed. The various example methods described and/or illustrated herein may also omit one or more of the steps described or illustrated herein or include additional steps in addition to those disclosed.

Some embodiments of the present disclosure may be able to provide reasonable fault detection accuracy for various different loading levels and/or drive control strategies. For example, embodiments of the present disclosure may identify faults with reasonable accuracy when loading the motors at 0%, 50%, and 100% maximum loads and/or when applying Scalar and Direct Torque Control or Direct-on-Line modes.

Accordingly, the present disclosure includes systems and methods that may provide one or more improvements over conventional motor fault detection systems.

The following example embodiments are also included in the present disclosure.

Example 1. An apparatus, including: an induction motor; an electrical current input for driving the induction motor; a current sensor for sensing electrical current at the electrical current input; an accelerometer for measuring vibration of at least one component of the induction motor; and a processor operatively coupled to the current sensor and the accelerometer, the processor configured to: receive current data from the current sensor and vibration data from the accelerometer during a time period including a plurality of time segments; calculate a frequency spectrum based on the current data for each time segment of the plurality of time segments; identify persistent sideband frequencies in the calculated frequency spectrum across the plurality of time segments; and compare the persistent sideband frequencies to known frequency signatures for multiple induction motor fault types and compare vibration data to a threshold to identify one fault type associated with the current data and vibration data of the multiple induction motor fault types.

Example 2. The apparatus of Example 1, wherein the at least one component of the induction motor includes a non-drive end of the induction motor.

Example 3. The apparatus of Example 1 or Example 2, wherein the electrical current input includes a three-phase electrical current input.

Example 4. The apparatus of Example 3, wherein the current sensor is configured to sense electrical current from a single phase of the three-phase electrical current input.

Example 5. The apparatus of any one of Examples 1 through 4, wherein the multiple induction motor fault types include: a broken rotor bar fault; a dynamic rotor eccentricity fault; a static rotor eccentricity fault; a mixed rotor eccentricity fault; an outer race bearing fault; an inner race bearing fault; a ball defect bearing fault; and a stator interturn short circuit fault.

Example 6. The apparatus of any one of Examples 1 through 5, wherein the processor calculating the frequency spectrum based on the current data for each time segment includes the processor applying a Fourier transform to the current data from each time segment.

Example 7. The apparatus of any one of Examples 1 through 6, wherein the processor is further configured to split the current data and vibration data into data sets corresponding to the plurality of time segments.

Example 8. The apparatus of any one of Examples 1 through 7, wherein the processor is further configured to determine a quantity of time segments in the plurality of time segments.

Example 9. The apparatus of any one of Examples 1 through 8, wherein the processor calculating the frequency spectrum based on the current data for each time segment includes the processor dynamically adjusting a resolution of the frequency spectrum calculation based on an operational speed of the induction motor.

Example 10. The apparatus of any one of Examples 1 through 9, wherein the processor is configured to perform data standardization using a T-score to convert the current data received from the current sensor into a common scale with healthy data that forms a basis of the known frequency signatures.

Example 11. The apparatus of any one of Examples 1 through 10, wherein the processor identifying persistent sideband frequencies includes the processor applying a deadzone to the frequency spectrum based on the current data using an Interquartile Range (IQR) method to identify and ignore normal oscillations and to identify changes indicative of a fault.

Example 12. An apparatus, including: a current sensor configured to measure an electrical current input for an induction motor to generate current data; an accelerometer configured to measure vibration of the induction motor to generate vibration data; a processor operatively coupled to the current sensor and the accelerometer; and non-transitory computer-readable memory storing instructions that, when executed by the processor, cause the processor to: segment the current data and the vibration data into multiple time segments to form segmented data; standardize the segmented data to form standardized, segmented data to facilitate comparison between healthy and faulty motor conditions; determine differences between the standardized, segmented data for each time segment and current and vibration data from a healthy motor; identify persistent sideband frequencies based on the standardized, segmented data across all time segments of the multiple time segments to determine fault signatures; and classify a type of fault associated with the current data and the vibration data based on the identified persistent sideband frequencies and vibration data, distinguishing between multiple induction motor faults.

Example 13. The apparatus of Example 12, wherein the instructions further cause the processor to reduce noise in the standardized, segmented data by applying at least one of: a moving average, or a median filter.

Example 14. The apparatus of Example 12 or Example 13, wherein the processor identifying persistent sideband frequencies includes identifying sideband frequencies that consistently exceed a predetermined threshold across all of the multiple time segments.

Example 15. The apparatus of any one of Examples 12 through 14, wherein the current sensor is configured to measure each phase of a three-phase electrical current input and to generate current data for each phase.

Example 16. The apparatus of any one of Examples 12 through 15, wherein the instructions further cause the processor to apply a deadzone to the standardized, segmented data using an Interquartile Range (IQR) method to filter out normal oscillations.

Example 17. The apparatus of any one of Examples 12 through 16, wherein the multiple induction motor faults include: a broken rotor bar fault; a dynamic rotor eccentricity fault; a static rotor eccentricity fault; a mixed rotor eccentricity fault; an outer race bearing fault; an inner race bearing fault; a ball defect bearing fault; and a stator interturn short circuit fault.

Example 18. A method, including: receiving, at a processor, current data from a current sensor coupled to an electrical current input for driving an induction motor and vibration data from an accelerometer coupled to the induction motor during a time period including multiple time segments; calculate, with the processor, a frequency spectrum based on the current data for each time segment of the multiple time segments; identify, with the processor, persistent sideband frequencies in the calculated frequency spectrum across the multiple time segments; and compare, with the processor, the persistent sideband frequencies to known frequency signatures for multiple induction motor fault types and compare vibration data to a threshold to identify one fault type associated with the current data and vibration data of the multiple induction motor fault types.

Example 19. The method of Example 18, further including storing, at a memory, a baseline set of healthy current data and healthy vibration data based on healthy operation of the induction motor for a variety of loading conditions.

Example 20. The method of Example 19, wherein comparing the persistent sideband frequencies to known frequency signatures and comparing vibration data to a threshold includes: determining whether the persistent sideband frequencies indicate a broken rotor bar fault; and if the persistent sideband frequencies do not indicate a broken rotor bar fault, analyzing the vibration data to determine whether a threshold is exceeded, indicating a bearing fault, or is not exceeded, indicating a rotor eccentricity fault or stator interturn short circuit fault.

The preceding description has been provided to enable others skilled in the art to best utilize various aspects of the example embodiments disclosed herein. This example description is not intended to be exhaustive or to be limited to any precise form disclosed. Many modifications and variations are possible without departing from the spirit and scope of the present disclosure. The embodiments disclosed herein should be considered in all respects illustrative and not restrictive. Reference should be made to the appended claims and their equivalents in determining the scope of the present disclosure.

Unless otherwise noted, the terms "connected to" and "coupled to" (and their derivatives), as used in the specification and claims, are to be construed as permitting both direct and indirect (i.e., via other elements or components) connection. In addition, the terms "a" or "an," as used in the specification and claims, are to be construed as meaning "at least one of." Finally, for ease of use, the terms "including" and "having" (and their derivatives), as used in the specification and claims, are interchangeable with and have the same meaning as the word "comprising."

## Claims

1. An apparatus, comprising:
an induction motor;
an electrical current input for driving the induction motor;
a current sensor for sensing electrical current at the electrical current input;
an accelerometer for measuring vibration of at least one component of the induction motor; and
a processor operatively coupled to the current sensor and the accelerometer, the processor configured to:
receive current data from the current sensor and vibration data from the accelerometer during a time period including a plurality of time segments;
calculate a frequency spectrum based on the current data for each time segment of the plurality of time segments;
identify persistent sideband frequencies in the calculated frequency spectrum across the plurality of time segments; and
compare the persistent sideband frequencies to known frequency signatures for multiple induction motor fault types and compare vibration data to a threshold to identify one fault type associated with the current data and vibration data of the multiple induction motor fault types.

2. The apparatus of claim 1, wherein the at least one component of the induction motor comprises a non-drive end of the induction motor.

3. The apparatus of claim 1 or 2, wherein the electrical current input comprises a three-phase electrical current input.

4. The apparatus of claim 3, wherein the current sensor is configured to sense electrical current from a single phase of the three-phase electrical current input.

5. The apparatus of one of the preceding claims, wherein the multiple induction motor fault types comprise:
a broken rotor bar fault;
a dynamic rotor eccentricity fault;
a static rotor eccentricity fault;
a mixed rotor eccentricity fault;
an outer race bearing fault;
an inner race bearing fault;
a ball defect bearing fault; and
a stator interturn short circuit fault.

6. The apparatus of one of the preceding claims, wherein the processor calculating the frequency spectrum based on the current data for each time segment comprises the processor applying a Fourier transform to the current data from each time segment.

7. The apparatus of one of the preceding claims, wherein the processor is further configured to split the current data and vibration data into data sets corresponding to the plurality of time segments.

8. The apparatus of one of the preceding claims, wherein the processor is further configured to determine a quantity of time segments in the plurality of time segments.

9. The apparatus of one of the preceding claims, wherein the processor calculating the frequency spectrum based on the current data for each time segment comprises the processor dynamically adjusting a resolution of the frequency spectrum calculation based on an operational speed of the induction motor.

10. The apparatus of one of the preceding claims, wherein the processor is configured to perform data standardization using a T-score to convert the current data received from the current sensor into a common scale with healthy data that forms a basis of the known frequency signatures.

11. The apparatus of one of the preceding claims, wherein the processor identifying persistent sideband frequencies comprises the processor applying a deadzone to the frequency spectrum based on the current data using an Interquartile Range (IQR) method to identify and ignore normal oscillations and to identify changes indicative of a fault.

12. An apparatus, comprising:
a current sensor configured to measure an electrical current input for an induction motor to generate current data;
an accelerometer configured to measure vibration of the induction motor to generate vibration data;
a processor operatively coupled to the current sensor and the accelerometer; and
non-transitory computer-readable memory storing instructions that, when executed by the processor, cause the processor to:
segment the current data and the vibration data into multiple time segments to form segmented data;
standardize the segmented data to form standardized, segmented data to facilitate comparison between healthy and faulty motor conditions;
determine differences between the standardized, segmented data for each time segment and current and vibration data from a healthy motor;
identify persistent sideband frequencies based on the standardized, segmented data across all time segments of the multiple time segments to determine fault signatures; and
classify a type of fault associated with the current data and the vibration data based on the identified persistent sideband frequencies and vibration data, distinguishing between multiple induction motor faults.

13. The apparatus of claim 12, wherein the instructions further cause the processor to reduce noise in the standardized, segmented data by applying at least one of: a moving average, or a median filter.

14. The apparatus of claim 12 or 13, wherein the processor identifying persistent sideband frequencies comprises identifying sideband frequencies that consistently exceed a predetermined threshold across all of the multiple time segments.

15. The apparatus of one of claims 12 to 14, wherein the current sensor is configured to measure each phase of a three-phase electrical current input and to generate current data for each phase.

16. The apparatus of one of claims 12 to 15, wherein the instructions further cause the processor to apply a deadzone to the standardized, segmented data using an Interquartile Range (IQR) method to filter out normal oscillations.

17. The apparatus of one of claims 12 to 16, wherein the multiple induction motor faults comprise:
a broken rotor bar fault;
a dynamic rotor eccentricity fault;
a static rotor eccentricity fault;
a mixed rotor eccentricity fault;
an outer race bearing fault;
an inner race bearing fault;
a ball defect bearing fault; and
a stator interturn short circuit fault.

18. A method, comprising:
receiving, at a processor, current data from a current sensor coupled to an electrical current input for driving an induction motor and vibration data from an accelerometer coupled to the induction motor during a time period including multiple time segments;
calculate, with the processor, a frequency spectrum based on the current data for each time segment of the multiple time segments;
identify, with the processor, persistent sideband frequencies in the calculated frequency spectrum across the multiple time segments; and
compare, with the processor, the persistent sideband frequencies to known frequency signatures for multiple induction motor fault types and compare vibration data to a threshold to identify one fault type associated with the current data and vibration data of the multiple induction motor fault types.

19. The method of claim 18, further comprising storing, at a memory, a baseline set of healthy current data and healthy vibration data based on healthy operation of the induction motor for a variety of loading conditions.

20. The method of claim 19, wherein comparing the persistent sideband frequencies to known frequency signatures and comparing vibration data to a threshold comprises:
determining whether the persistent sideband frequencies indicate a broken rotor bar fault; and
if the persistent sideband frequencies do not indicate a broken rotor bar fault, analyzing the vibration data to determine whether a threshold is exceeded, indicating a bearing fault, or is not exceeded, indicating a rotor eccentricity fault or stator interturn short circuit fault.
